(19) Europäisches Patentamt / European Patent Office / Office européen des brevets

(11) **EP 3 172 827 B1**

(12) **EUROPÄISCHE PATENTSCHRIFT**

(45) Veröffentlichungstag und Bekanntmachung des Hinweises auf die Patenterteilung:
**02.09.2020  Patentblatt 2020/36**

(21) Anmeldenummer: **15817765.9**

(22) Anmeldetag: **17.07.2015**

(51) Int Cl.:
*H02P 9/00* (2006.01)    *H02P 9/10* (2006.01)
*H02P 29/024* (2016.01)   *H02P 3/22* (2006.01)

(86) Internationale Anmeldenummer:
**PCT/EP2015/066396**

(87) Internationale Veröffentlichungsnummer:
**WO 2016/012360 (28.01.2016 Gazette 2016/04)**

(54) **VERFAHREN ZUM BETREIBEN EINER ZUMINDEST GENERATORISCH BETREIBBAREN ELEKTRISCHEN MASCHINE UND MITTEL ZU DESSEN IMPLEMENTIERUNG**

METHOD FOR OPERATING AN AT LEAST GENERATOR-OPERABLE ELECTRIC MOTOR AND MEANS FOR THE IMPLEMENTATION THEREOF

PROCÉDÉ PERMETTANT DE FAIRE FONCTIONNER UN MOTEUR ÉLECTRIQUE POUVANT AU MOINS FONCTIONNER AU MOYEN D'UN GÉNÉRATEUR ET MOYENS PERMETTANT LA MISE EN OEUVRE DUDIT PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.07.2014  DE 102014214720**
**05.05.2015  DE 102015208302**

(43) Veröffentlichungstag der Anmeldung:
**31.05.2017  Patentblatt 2017/22**

(73) Patentinhaber: **SEG Automotive Germany GmbH 70499 Stuttgart (DE)**

(72) Erfinder: **MEHRINGER, Paul 70569 Stuttgart (DE)**

(74) Vertreter: **Steinbauer, Florian et al Dehns Germany Theresienstraße 6-8 80333 München (DE)**

(56) Entgegenhaltungen:
**EP-A1- 2 706 657          WO-A1-2013/065512**
**DE-A1- 4 038 301          DE-A1-102006 003 254**
**DE-A1-102009 046 955**

**Beschreibung**

Die vorliegende Erfindung betrifft ein Verfahren zum Betreiben einer zumindest generatorisch betreibbaren elektrischen Maschine mit einem aktiven Brückengleichrichter und Mittel zu dessen Implementierung.

Stand der Technik

Die Europäische Patentanmeldung EP 2 706 657 A1 offenbart ein Verfahren zum Ansteuern einer elektrischen Maschine.

Herkömmlicherweise kommen in Personenkraftwagen Generatoren in Klauenpolbauweise mit passiven Brückengleichrichtern zum Einsatz. Die Leistung solcher Generatoren wird über das Erregerfeld und dieses wiederum durch den Erregerstrom eingestellt. Durch die Regelung des Erregerfeldes kann die durch den Generator über den Brückengleichrichter bereitgestellte Ausgangsspannung unabhängig von Netzlast, Drehzahl und Temperatur konstant gehalten werden.

Ist nachfolgend vereinfacht von einem Generator die Rede, kann es sich hierbei auch um eine sowohl generatorisch als auch motorisch betreibbare elektrische Maschine handeln, beispielsweise um einen sogenannten Startergenerator. Die Erfindung eignet sich nicht nur für Generatoren in Klauenpolbauweise, sondern für alle zumindest generatorisch betreibbaren elektrischen Maschinen. In Personenkraftwagen werden in Entsprechung zu den üblicherweise verbauten drei-, vier- oder fünfphasigen Generatoren üblicherweise Brückengleichrichter in sechs-, acht- oder zehnpulsiger Ausführung verwendet. Die Erfindung eignet sich jedoch auch für Brückengleichrichter für andere Phasenzahlen.

Ein Lastsprung im angeschlossenen Netz, beispielsweise durch Zu- oder Abschaltung eines Verbrauchers, führt zu einem Lastsprung am Generator. Da die Abgabeleistung des Generators aber aufgrund der Induktivität des Erregerfeldes nicht beliebig schnell geändert werden kann, bleibt der Generatorstrom zunächst konstant, was bei einem Lastabwurf (engl. Load Dump) zu einer deutlichen Erhöhung der Ausgangsspannung führen kann. Der Abbau des Erregerfeldes kann einige hundert Millisekunden in Anspruch nehmen.

Solange eine Batterie im Bordnetz vorhanden ist, kann diese die überschüssige Generatorleistung in der Regel aufnehmen und damit einen übermäßigen Spannungsanstieg verhindern. Ist jedoch keine Batterie vorhanden, so steigt die Ausgangsspannung sehr schnell an und ist in der Lage, Bordnetzkomponenten und/oder den Generator zu beschädigen.

Bei Generatoren mit passiven Brückengleichrichtern wird dies verhindert, indem als Gleichrichterdioden Zenerdioden verwendet werden. Die Zenerdioden klammern die Ausgangsspannung oberhalb ihrer Durchbruchsspannung und sind daher in der Lage, überschüssigen Strom aufzunehmen und in Wärme umzusetzen. Auf diese Weise ist ein sicherer Betrieb des Generators gewährleistet.

Anstelle von Dioden können in Brückengleichrichtern auch ein- und ausschaltbare, steuerbare Stromventile, insbesondere MOSFET, verwendet werden, entsprechende Brückengleichrichter werden dann als aktive Brückengleichrichter bezeichnet. Vorteil ist ihre geringere Verlustleistung im eingeschalteten Zustand und damit der bessere Wirkungsgrad, insbesondere im Teillastbetrieb.

Die Steuerung der Stromventile kann zentral oder dezentral erfolgen. Unter einer zentralen Steuerung wird verstanden, dass eine gemeinsame Steuereinheit alle Wechselstromphasen überwacht und alle Stromventile und optional auch das Erregerfeld des Generators steuert. Unter einer dezentralen Steuerung wird verstanden, dass jeweils eine Steuereinheit eine Generatorphase überwacht und in Abhängigkeit von der Phasenspannung nur die der jeweiligen Phase zugeordneten Stromventile, also nur die Stromventile jeweils einer Halbbrücke des Brückengleichrichters, steuert. Es findet typischerweise keine Kommunikation zwischen einzelnen dezentralen Steuereinheiten statt.

Eine Möglichkeit, bei einem Lastabwurf Spannungsspitzen im Bordnetz zu verhindern, besteht bei aktiven Brückengleichrichtern darin, die Stromventile des oberen oder des unteren Gleichrichterzweigs (also alle Highside- oder alle Lowside-Stromventile) jeweils in allen Halbbrücken einzuschalten. Auf diese Weise wird die elektrische Maschine intern kurzgeschlossen, jedoch nicht das angeschlossene Netz, weil die Stromventile des jeweils anderen Gleichrichterzweigs nicht eingeschaltet sind.

Die erläuterten Maßnahmen werden nachfolgend auch als Phasenkurzschluss bezeichnet. Ein Phasenkurzschluss wird gemäß dem hier verwendeten Sprachgebrauch also durch das Einschalten (Leitendschalten) aller Stromventile des jeweiligen Gleichrichterzweigs eingeleitet und entsprechend durch das Ausschalten dieser Stromventile wieder aufgehoben. Eingeschaltet werden die Halbleiterventile dabei durch Bereitstellen einer entsprechenden Steuerspannung an ihrem Gateanschluss (Ansteuern), wodurch die Drain-Source-Strecke der Halbleiterventile leitend bzw. niederohmig wird. Entsprechend werden die Halbleiterventile ausgeschaltet, indem die Bereitstellung der Steuerspannung beendet und die Drain-Source-Strecke damit nichtleitend bzw. hochohmig wird. Außerhalb eines Phasenkurzschlusses liegt ein regulärer Gleichrichterbetrieb vor.

Ein Phasenkurzschluss kann beispielsweise dann eingeleitet werden, wenn die Spannung zwischen den Gleichspannungsanschlüssen des Brückengleichrichters (üblicherweise mit B+ und B- bezeichnet) bzw. zwischen dem spannungsführenden Gleichspannungsanschluss und Masse, einen oberen Schwellwert überschreitet. Der Phasenkurzschluss kann wieder aufgehoben werden, wenn diese Spannung danach einen unteren Schwellwert unterschreitet. Auch eine Zeitsteuerung kann verwendet werden.

Ist das Erregerfeld zum Zeitpunkt, zu dem der Phasenkurzschluss aufgehoben wird, noch nicht ausreichend abgebaut, steigt die Spannung zwischen den Gleichspannungsanschlüssen des Brückengleichrichters nach der Aufhebung des Phasenkurzschlusses erneut an und überschreitet wieder den oberen Schwellwert. Bis zum vollständigen oder ausreichenden Abbau des Erregerfeldes werden Phasenkurzschlüsse daher mehrfach eingeleitet und aufgehoben. Wie erwähnt, kann der Abbau des Erregerfeldes mehrere hundert Millisekunden in Anspruch nehmen, die Schaltphasen der Einleitung und Aufhebung der Phasenkurzschlüsse betragen demgegenüber typischerweise nur wenige Millisekunden. Bis zum Abbau des Erregerfelds wird daher über einen beträchtlichen Zeitraum, der nachfolgend auch als Entregungszeitraum bezeichnet wird, zwischen Phasenkurzschlüssen und regulärer Gleichrichtung hin- und hergeschaltet. Hierbei kommt es zu beträchtlichen Verlustleistungen, insbesondere während der Phasenkurzschlüsse. Dies kann zu erheblichen Belastungen und vorzeitigem Ausfall der beteiligten Stromventile führen.

Es ist daher wünschenswert, die Belastung von entsprechenden Stromventilen während des Entregungszeitraums zu verringern.

Offenbarung der Erfindung

Vor diesem Hintergrund werden ein Verfahren zum Betreiben einer zumindest generatorisch betreibbaren elektrischen Maschine mit einem aktiven Brückengleichrichter und Mittel zu dessen Implementierung mit den Merkmalen der unabhängigen Patentansprüche vorgeschlagen. Ausgestaltungen sind Gegenstand der abhängigen Patentansprüche sowie der nachfolgenden Beschreibung.

Vorteile der Erfindung

Die vorliegende Erfindung geht von einem Verfahren zum Ansteuern einer zumindest generatorisch betreibbaren, mehrphasigen elektrischen Maschine aus, deren Phasenanschlüsse in einem aktiven Brückengleichrichter jeweils überein- und ausschaltbare, ansteuerbare erste Stromventile an einen ersten Gleichspannungsanschluss und über zweite Stromventile an einen zweiten Gleichspannungsanschluss angebunden sind, wobei das Verfahren umfasst, in einem generatorischen Betrieb der elektrischen Maschine nach Auftreten eines Lastabwurfs mehrfach Phasenkurzschlüsse der Phasenanschlüsse über die ersten Stromventile einzuleiten und aufzuheben. Wie erläutert, erfolgt das Einleiten und Aufheben der Phasenkurzschlüsse durch die Ansteuerung der entsprechenden ein- und ausschaltbaren, ansteuerbaren Stromventile. Ein Lastabwurf wird insbesondere durch Auswerten der zwischen den Gleichspannungsanschlüssen anliegenden Spannung erkannt. Liegt diese beispielsweise oberhalb eines oberen Schwellwerts, liegt ein Lastabwurf vor.

Erfindungsgemäß ist vorgesehen, dass eine eine Eigenfrequenz der elektrischen Maschine kennzeichnende Größe ermittelt und die ersten Stromventile zum Einleiten und Aufheben der Phasenkurzschlüsse auf Grundlage der die Eigenfrequenz der elektrischen Maschine kennzeichnenden Größe mit einer Schaltfrequenz angesteuert werden. Dies kann, wie nachfolgend erläutert, insbesondere durch eine entsprechende Einstellung von Schwellwerten, ggf. aber auch unter zusätzlicher oder ausschließlicher Verwendung einer Zeitsteuerung, erfolgen.

Die die Eigenfrequenz der elektrischen Maschine kennzeichnende Größe kann ein berechneter Eigenfrequenzwert sein, beispielsweise ein Eigenfrequenzwert, der aus einer momentanen Drehzahl des Rotors der elektrischen Maschine bzw. deren Umlaufdauer und der Polpaarzahl abgeleitet wird. Es kann sich aber auch um einen aus einem Strom- oder Spannungssignal ermittelten Wert handeln, wie unten erläutert. Die Eigenfrequenz der elektrischen Maschine ist jedoch auch durch die Periodendauer der Eigenfrequenz gekennzeichnet, die sich ebenfalls aus der Drehzahl des Rotors der elektrischen Maschine bzw. deren Umlaufdauer und der Polpaarzahl ermitteln lässt. Da auch bereits die zum Zeitpunkt der Durchführung des Verfahrens vorliegende Drehzahl des Rotors der elektrischen Maschine (zusammen mit der Polpaarzahl, wie unten erläutert) die Eigenfrequenz kennzeichnet, handelt es sich bei einem entsprechend ermittelten Drehzahlwert oder einer abgeleiteten Größen bereits um eine die Eigenfrequenz kennzeichnende Größe. Aus der ermittelten Drehzahl der elektrischen Maschine zum Zeitpunkt der Durchführung des Verfahrens kann zusammen mit der Polpaarzahl die Eigenfrequenz oder deren Periodendauer bestimmt werden.

Die Erfindung schlägt grundsätzlich vor, die Einleitung und Aufhebung der Phasenkurzschlüsse abgestimmt mit bzw. synchronisiert zu der Eigenfrequenz der elektrischen Maschine vorzunehmen. Wie auch nachfolgend erläutert, muss, damit sich die Vorteile des erfindungsgemäßen Verfahrens einstellen, die Schaltfrequenz nicht genau der Eigenfrequenz entsprechen. Es reicht beispielsweise aus, wenn die Schaltfrequenz in einem Frequenzbereich liegt, dessen Untergrenze ein ganzzahliges Vielfaches der Eigenfrequenz abzüglich eines vorgegebenen Toleranzwerts und dessen Obergrenze das ganzzahlige Vielfache der Eigenfrequenz zuzüglich des vorgegebenen Toleranzwerts beträgt. Konkrete Zahlenwerte sind unten erläutert. Ferner kann auch eine Periodendauer der Schaltfrequenz in einem Zeitbereich liegen, dessen Untergrenze ein ganzzahliges Vielfaches einer Periodendauer der Eigenfrequenz abzüglich eines Toleranzwerts und dessen Obergrenze das ganzzahlige Vielfache der Periodendauer der Eigenfrequenz zuzüglich des Toleranzwerts beträgt. Entsprechende Toleranzwerte ermöglichen eine einfachere und kostengünstigere Regelung.

Ein entsprechendes Verfahren umfasst vorteilhafterweise, dass die ersten Stromventile zum Einleiten der Phasenkurzschlüsse auf Grundlage von Einschaltbedingungen eingeschaltet und zum Aufheben der Phasenkurzschlüsse auf Grundlage von Ausschaltbedingungen ausgeschaltet werden, wobei die Ein- und/oder die Ausschaltbedingungen auf Grundlage der die Eigenfrequenz der elektrischen Maschine kennzeichnenden Größe vorgegeben werden.

Die Einschaltbedingungen können zumindest umfassen, dass eine Ausgangsspannung zwischen dem ersten Gleichspannungsanschluss und dem zweiten Gleichspannungsanschluss einen oberen Schwellwert überschritten hat, wobei der obere Schwellwert (zumindest) in Abhängigkeit von der die Eigenfrequenz der elektrischen Maschine kennzeichnenden Größe eingestellt, d.h. erhöht oder verringert wird.

Entsprechend können die Ausschaltbedingungen zumindest umfassen, dass eine Ausgangsspannung zwischen dem ersten Gleichspannungsanschluss und dem zweiten Gleichspannungsanschluss einen unteren Schwellwert unterschritten hat, wobei der untere Schwellwert (zumindest) in Abhängigkeit von der die Eigenfrequenz der elektrischen Maschine kennzeichnenden Größe eingestellt, d.h. erhöht oder verringert wird. Die Abstimmung über die Schwellwerte kann beispielsweise auf Grundlage bekannter Maschinenparameter erfolgen, wie nachfolgend anhand eines Beispiels erläutert.

Angenommen, eine Kapazität $C_{B+}$ am positiven Gleichspannungsanschluss B+ des eingesetzten Brückengleichrichters werde während der Kurzschlussphasen über einen konstanten Strom $I_V$ entladen, so fällt die Spannung am Kondensator $C_{B+}$ konstant gemäß Gleichung 1 ab:

$$U_{B+} = U_{B+,0} + t \times I_V / C_{B+} \qquad\qquad (1)$$

Die Ableitung ergibt einen Wert $D_u$:

$$D_u = I_V \times D_t / C_{B+} \qquad\qquad (2)$$

Ferner ist durch die Drehzahl n eines Rotors der elektrischen Maschine, die hier in 1/s angegeben, jedoch auch auf eine andere Zeitbasis beziehbar ist, bzw. deren Kehrwert, also die Umlaufdauer T, und die Polpaarzahl P die elektrische Eigenfrequenz $f_E$ des Generators bzw. deren Periodendauer $T_E$ gegeben über

$$f_E = n \times P \quad bzw. \quad T_E = 1 / (n \times P) = P / T. \qquad\qquad (3)$$

Nun sollen die Zeit für die elektrische Umlauffrequenz und die Zeit des Abfalls der Spannung am positiven Gleichspannungsanschluss B+ synchronisiert werden. Setzt man $T_E$ aus Gleichung 3 in Gleichung 2 ein, so ergibt sich:

$$D_u = I_V \times T_E / C_{B+} \qquad\qquad (4)$$

Der Wert $D_u$ entspricht in diesem Fall in erster Näherung der Differenz zwischen der Spannung, bei der ein Kurzschluss aktiviert wird, und der Spannung, bei der der Kurzschluss wieder gelöst wird. Beispielsweise durch eine Variation des Spannungswertes, bei dem der Kurzschluss gelöst wird, also des unteren Schwellwerts, kann also der gewünschte Zustand herbeigeführt werden.

Gemäß einer vorteilhaften Ausführungsform der Erfindung erfolgt die Einstellung also zusätzlich zu der bereits erwähnten Abhängigkeit von der die Eigenfrequenz der elektrischen Maschine kennzeichnenden Größe auch in Abhängigkeit von einem Entladestrom eines mit dem ersten und/oder zweiten Gleichspannungsanschluss verbundenen kapazitiven Elements und dessen Kapazität. Weitere Größen können ebenfalls berücksichtigt werden.

Alternativ kann auch direkt eine Zeitsteuerung oder ein gemischtes Verfahren eingesetzt werden. Dies bedeutet, dass die Einschaltbedingungen zumindest umfassen können, dass ein vorgegebener Einschaltzeitpunkt erreicht ist und/oder dass die Ausschaltbedingungen zumindest umfassen können, dass ein vorgegebener Ausschaltzeitpunkt erreicht ist. Entsprechende Zeitpunkte können insbesondere auf Grundlage von Maschinenfrequenzen vorgegeben werden.

Im Rahmen der vorliegenden Anmeldung wird unter einem ein- und ausschaltbaren, ansteuerbaren Stromventil ein Halbleiterschalter verstanden, der so lange eine niederohmige bzw. leitende Verbindung bereitstellt, so lange an einem hierfür vorgesehenen Anschluss eine Ansteuerspannung anliegt. Insbesondere handelt es sich bei derartigen ein- und ausschaltbaren, ansteuerbaren Stromventilen um Halbleiterschalter wie MOSFET und/oder IGBT, die über ihren Gateanschluss angesteuert werden und die niederohmige bzw. leitende Verbindung über die Drain-Source-Strecke bereitstellen. Nur einschaltbare ansteuerbare Stromventile, die nicht Gegenstand der vorliegenden Erfindung sind, sind beispielsweise Thyristoren. Dioden sind ebenfalls Stromventile, aber nicht ansteuerbar.

Die vorliegende Erfindung beruht auf der Feststellung, dass die Dauer des Zeitraums, während dessen zwischen Phasenkurzschluss und regulärem Gleichrichterbetrieb hin- und hergeschaltet wird, durch den Abbau des Erregerfeldes bzw. des Erregerstroms des Generators vorgegeben ist und durch eine Aufprägung bzw. Verstärkung von Schwingungen in dem Erregerfeld bzw. dem Erregerstrom beträchtlich reduziert werden kann. Die Aufprägung bzw. Verstärkung der Schwingungen ist besonders effektiv, wenn die Schaltfrequenz des Ein- und/oder Ausschaltens der ersten Stromventile mit dieser Frequenz durch die zuvor erläuterte Ansteuerung der Stromventile zumindest teilweise synchronisiert wird, wie nachfolgend erläutert. Die Erfindung nutzt also die Eigenschwingung des verwendeten Systems aus, um einen entsprechenden Zeitraum zu verkürzen und damit die Belastung der beteiligten Stromventile zu verringern. Die Belastung der Stromventile wird auch dadurch beträchtlich verringert, dass die verlustbehafteten Schaltvorgänge zu Zeitpunkten erfolgen, an denen momentan ein niedriger Phasenstrom anliegt.

Durch die erfindungsgemäßen Maßnahmen, die sowohl eine signifikante Verkürzung eines entsprechenden Zeitraums ermöglichen, als auch Schaltvorgänge zu Zeitpunkten niedriger Phasenströme, erlauben damit die Reduzierung der Verlustleistung in den beteiligten Stromventilen und letztlich eine Erhöhung der Robustheit eines entsprechenden Systems.

Wenngleich hier überwiegend auf Lastabwürfe Bezug genommen wird, die sich aus einer Lastabschaltung, insbesondere im batterielosen Betrieb, ergeben, eignet sich das erfindungsgemäße Verfahren grundsätzlich auch für Fälle, in denen entsprechende Lastabwürfe aus einem Kabelabriss, beispielsweise am positiven Gleichspannungsanschluss des Brückengleichrichters, resultieren. In ersterem Fall, d.h. der Lastabschaltung im batterielosen Betrieb, liefert der Generator für eine Übergangszeit von bis zu einer Sekunde mehr Strom, als das Netz aufnehmen kann. Es kommt, wie eingangs erwähnt, zu einer Überspannung, die insbesondere angeschlossene Steuergeräte schädigen kann. Das Netz muss jedoch ggf. weiter versorgt werden, da im batterielosen Betrieb keine Batterieversorgung als Übergangslösung möglich ist. Bei einem Kabelabriss liefert der Generator ebenfalls weiterhin Strom, es sind jedoch keine Verbraucher mehr angeschlossen, die gefährdet werden könnten. Ist eine Batterie vorhanden, können Verbraucher übergangsweise aus dieser versorgt werden. Ohne weitere Gegenmaßnahme liefert aber auch hier der Generator weiter Strom, was zu einem Anstieg der Spannung, beispielsweise am positiven Gleichspannungsanschluss, und zu einer Zerstörung der Leistungselektronik des Generators führen kann.

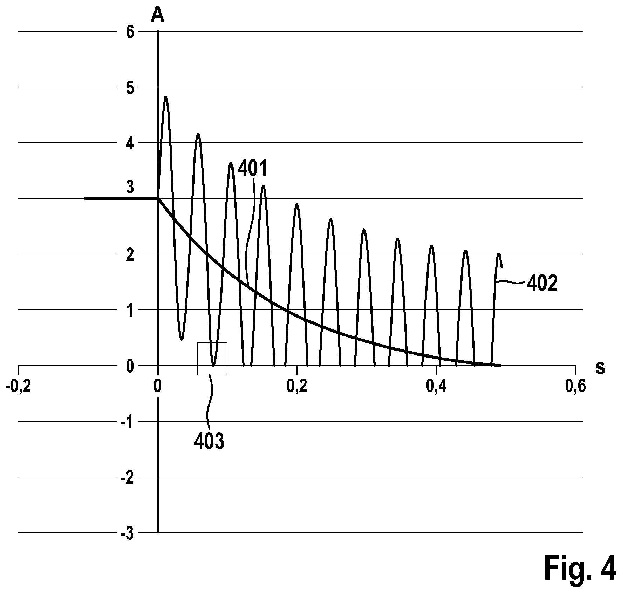

Wie auch in der beigefügten Figur 4 gezeigt, ist die Dauer des Zeitraums, währenddessen zwischen regulärer Gleichrichtung und Phasenkurzschlüssen hin- und hergeschaltet wird, abhängig vom Verlauf des Erregerstroms, der im Freilauf in erster Näherung einer exponentiellen Abklingkurve folgt. Wie ebenfalls aus Figur 4 ersichtlich, richtet sich die Dauer der Abklingkurve, bzw. die Dauer, bis eine derartige Abklingkurve einen Nullwert erreicht oder ausreichend approximiert, in erster Linie nach dem Anfangswert des entsprechenden Stroms.

Nimmt man die Erregerwicklung beispielsweise als Spule mit 2 $\Omega$ Widerstand und 400 mH Induktivität an, deren Strom über eine Diode gelöscht wird, kann gezeigt werden, dass bei der Anwendung von Stoßkurzschlüssen eine Schwingung vom Stator auf den Läufer aufgeprägt werden kann, die den Zeitpunkt, zu dem der Erregerstrom erstmals den Nullwert (0 A) erreicht, deutlich verringert und damit früher in die reguläre Gleichrichtung übergegangen werden kann. Ohne Schwingungen wird dieser Wert erstmalig bei ca. 400 ms erreicht, bei einer überlagerten Schwingung bereits nach ca. 80 ms. Der Zeitpunkt wird desto früher erreicht, je höher die Amplitude der überlagerten Schwingung ist. Die Amplitude ist wiederum abhängig davon, wie gut eine Resonanzbedingung erfüllt ist, welche im Folgenden erläutert wird.

Es sei darauf hingewiesen, dass die hohen Verlustleistungsenergien in den beteiligten Stromventilen nicht durch die in der Erregerspule gespeicherte Energie entstehen, sondern vielmehr durch die kontinuierliche Stromerzeugung, solange der Erregerstrom nicht vollständig abgeklungen ist:

Die normalerweise in der Erregerspule gespeicherte Energie E beträgt im erläuterten Beispiel bei 6 A und 400 mH beispielsweise 3 $A^2 \times$ 400 mH = 3,6 J. Die auftretenden Energien in den beteiligten Stromventilen bei einem Lastabwurf sind hingegen um ein Vielfaches höher. Nimmt man einen Generator mit 100 A Ausgangsstrom an und klammert diesen gegen 36 V, so sind die erwähnten 3,6 J bereits nach einem Zeitraum von 1 ms erreicht.

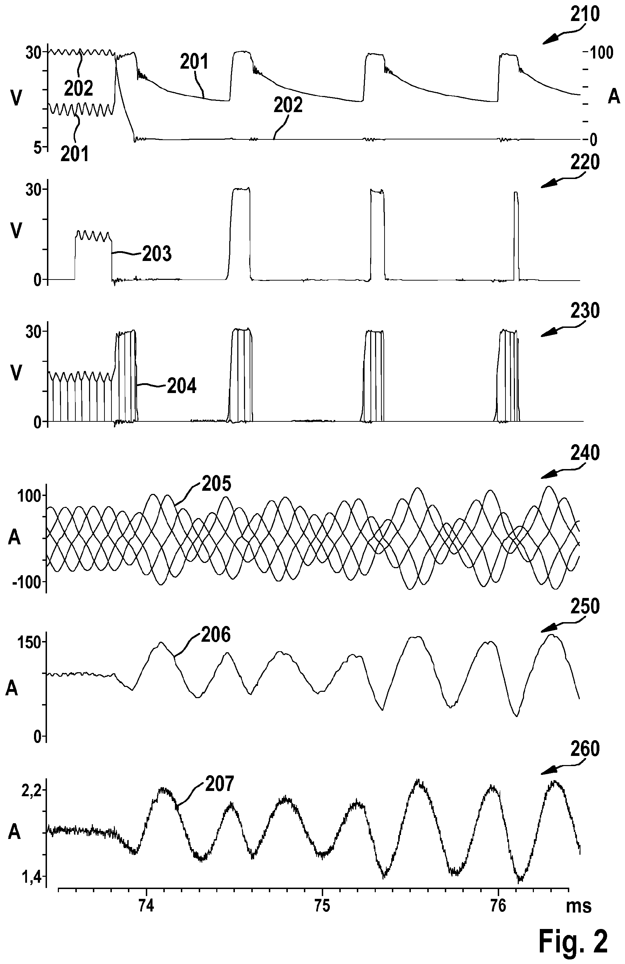

Wie auch in der nachfolgend erläuterten Figur 2 ersichtlich und dort ausführlich diskutiert, kommt es in Zeiträumen aktiver Gleichrichtung zu einer Reduzierung im theoretischen Abgabestrom des Generators, wohingegen während der Phasenkurzschlüsse ein Aufschwingen der Phasenströme zu beobachten ist. Der Erregerstrom schwingt mit gleicher Frequenz und gleicher Phasenlage wie die Phasenströme. Es handelt sich hierbei um eine erzwungene Eigenschwingung mit einer Eigenfrequenz $f_E = (n \times P)$ (siehe Gleichung 3), wobei n die Generatordrehzahl in Umdrehungen pro Sekunde und P die Polpaarzahl angibt. Für eine Generatordrehzahl in Umdrehungen pro Minute (rpm) ergäbe sich die Eigenfrequenz zu $f_E = (n \times P) / 60$.

Um die Verlustleistung in den beteiligten Stromventilen möglichst gering zu halten, müssen die Schaltvorgänge zu den Zeitpunkten erfolgen, in denen die Phasenströme niedrig sind. Die sich aufgrund der Einleitung und Aufhebung der Phasenkurzschlüsse ergebende Frequenz $f_B+$ der Schwingung in der Ausgangsspannung des Gleichrichters, d.h. der Spannung, die zwischen den positiven Gleichspannungsanschlüssen des Gleichrichters anliegt, wird durch die an die Gleichspannungsanschlüsse angeschlossene Kapazität $C_{B+}$, den Entladestrom $I_E$, der der Kapazität entzogen wird, und die Differenzspannung der hinterlegten Schaltschwellen $U_S$ für die Einleitung und Aufhebung der Phasenkurzschlüsse (im Rahmen dieser Anmeldung mit oberer und unterer Schwellwert bezeichnet), bestimmt, was mit $f_{B+} = f(C_{B+}, I_E, U_S)$ ausgedrückt werden kann.

Da die an den Gleichspannungsanschlüssen angeschlossene Kapazität sowie der Strom, der der Kapazität entzogen wird, im Betrieb nicht veränderbar sind, wird im Rahmen der vorliegenden Anmeldung unter anderem vorgeschlagen, die Schaltschwellen zur Aktivierung und Deaktivierung des Phasenkurzschlusses, d.h. den oberen und/oder unteren Schwellwert, entsprechend zu verändern, so dass die Frequenz $f_{B+}$ der Schwingung in der Ausgangsspannung des Gleichrichters der Frequenz der Eigenschwingung $f_E$ angepasst wird, wobei, wie nachfolgend erläutert, die Bedingung $f_E = f_{B+}$ oder $f_E \approx f_{B+}$ oder $xf_E = f_{B+}$ oder $xf_E \approx f_{B+}$ erfüllt sein sollte (x gibt beispielsweise eine ganze Zahl von 1 bis 5 an). Alternativ dazu kann auch ein gemischtes Verfahren verwendet werden, bei dem die Dauer der Phasenkurzschlüsse bzw. deren Schaltfrequenz zeitgesteuert abläuft.

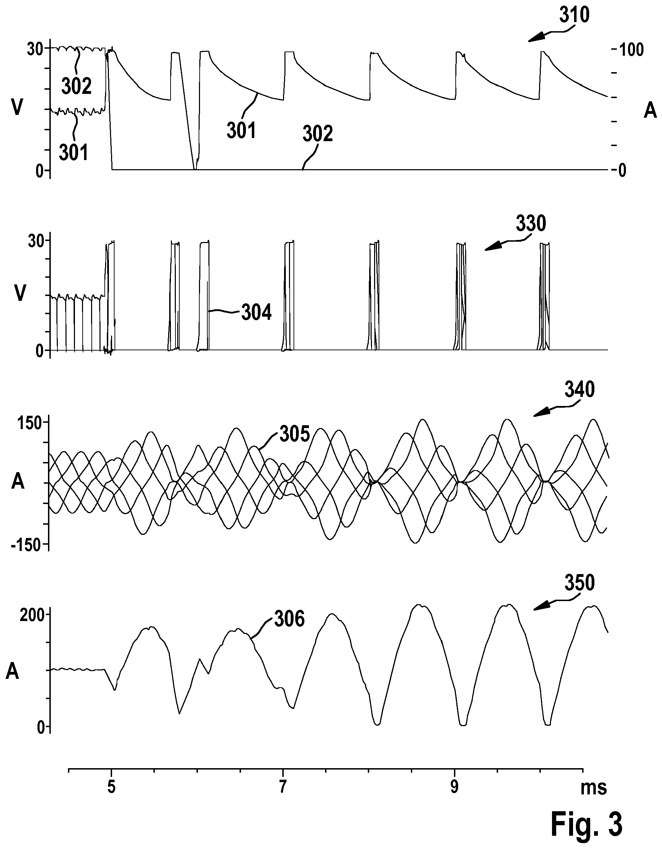

Wie auch in der nachfolgend erläuterten Figur 3 gezeigt, kann durch eine zeitrichtige, d.h. im Wesentlichen phasensynchrone Aktivierung und Deaktivierung der Phasenkurzschlüsse, ein starkes Abschwingen des gleichgerichteten Stroms erreicht werden. Hierdurch kann sichergestellt werden, dass der Zeitraum, während dessen zwischen regulärer Gleichrichtung und Phasenkurzschlüssen hin- und her geschaltet wird, bereits nach sehr kurzer Zeit, beispielsweise nach etwa 4 ms beendet werden kann. Ein derartiger Zeitpunkt ist erreicht, wenn sich alle Phasenströme auf den Wert Null aufaddieren. Zu diesem Zeitpunkt ist der Generator bereits vollständig entregt. Allerdings wird aufgrund des herkömmlicherweise eingesetzten Algorithmus der Phasenkurzschluss wieder eingeleitet und die Restremanenz des Generators erzeugt gegenüber einer Gegenspannung von 0 V wieder Phasenströme oberhalb von 0 V.

Während des aktiven Gleichrichterbetriebs kann anhand der Phasenspannungsverläufe jederzeit die zugrundeliegende Drehzahl mitverfolgt werden und eine Berechnung der entsprechenden, gewünschten Schaltfrequenz erfolgen. Sobald anhand der Spannung am positiven Gleichspannungsanschluss B+ das Vorliegen eines Lastabwurfs erkannt wird, wird die Schaltfrequenz zwischen den Gleichrichterphasen an die gewünschte Schaltfrequenz angepasst. Wird nun während eines entsprechenden Lastabwurfsbetriebs erkannt, dass die Phasenströme bzw. der Erregerstrom zu einem Zeitpunkt (aufsummiert) 0 A erreichen, kann auf eine weitere Aktivierung von Phasenkurzschlüssen verzichtet werden, da die elektrische Maschine ab diesem Zeitpunkt ausreichend entregt ist.

Vorteilhafterweise kann also im Rahmen der vorliegenden Erfindung die die Eigenfrequenz der elektrischen Maschine kennzeichnende Größe, mit dessen Frequenz die Schaltfrequenz des Einleitens und Aufhebens der Phasenkurzschlüsse zumindest teilweise synchronisiert wird, gemessen oder aus einer Drehzahl der elektrischen Maschine bestimmt werden.

Das erfindungsgemäße Verfahren erweist sich, wie erwähnt, als besonders vorteilhaft, weil es nicht erforderlich ist, eine Resonanzbedingung $f_E = f_{B+}$ exakt einzuhalten, da es sich im vorliegenden Fall um eine erzwungene Schwingung handelt. Wie bereits erläutert, ergeben sich die Vorteile des erfindungsgemäßen Verfahrens bereits dann, wenn eine Bedingung $f_E \approx f_{B+}$ oder $xf_E = f_{B+}$ oder $xf_E \approx f_{B+}$ erfüllt ist. Mit anderen Worten kann die erfindungsgemäße zumindest teilweise Synchronisation derart erfolgen, dass die Eigenfrequenz der elektrischen Maschine in einem Frequenzbereich um die Schaltfrequenz oder eines Vielfachen der Schaltfrequenz liegt. Die Schaltfrequenz (oder ein Vielfaches) muss also nicht genau durch die Eigenfrequenz getroffen werden und umgekehrt, wie bereits oben erwähnt. Auch eine Umschaltung zwischen Phasenkurzschluss und aktiver Gleichrichtung bzw. zurück nur zu jedem zweiten, dritten, vierten usw. Minimum des Eigenfrequenzsignals ermöglicht die erfindungsgemäß als vorteilhaft erkannte Erhöhung der Eigenschwingung. Eine "Synchronisation" bezeichnet daher im Rahmen der vorliegenden Erfindung nicht notwendigerweise ein Gleichsetzen der beiden erwähnten Frequenzen. Die Synchronisation kann vielmehr auch derart erfolgen, dass die Eigenfrequenz zuzüglich oder abzüglich eines optionalen Toleranzwerts gleich der Schaltfrequenz der Phasenkurzschlüsse oder eines ganzzahligen Vielfachen hiervon ist.

Mit nochmals anderen Worten ausgedrückt ist vorteilhafterweise vorgesehen, dass, wenn die Eigenfrequenz der elektrischen Maschine $f_E$ beträgt, die Schaltfrequenz der ersten Stromventile $(f_E \times m) \pm (k \times f_E)$ beträgt, wobei m eine ganze Zahl von 1 bis 5 ist und k in einem Bereich von 0 bis 0,4 liegt. Der Wert m stellt, bei Werten größer eins, das erwähnte ganzzahlige Vielfache und der Wert m einen den optionalen Toleranzwert definierenden Wert dar.

Eine erfindungsgemäße Recheneinheit, z.B. ein Steuergerät eines Kraftfahrzeugs, ist, insbesondere programmtechnisch, dazu eingerichtet, ein erfindungsgemäßes Verfahren durchzuführen.

Auch die Implementierung des Verfahrens in Form von Software ist vorteilhaft, da dies besonders geringe Kosten verursacht, insbesondere wenn ein ausführendes Steuergerät noch für weitere Aufgaben genutzt wird und daher ohnehin vorhanden ist. Geeignete Datenträger zur Bereitstellung des Computerprogramms sind insbesondere Disketten, Festplatten, Flash-Speicher, EEPROMs, CD-ROMs, DVDs u.a.m. Auch ein Download eines Programms über Computernetze (Internet, Intranet usw.) ist möglich.

Weitere Vorteile und Ausgestaltungen der Erfindung ergeben sich aus der Beschreibung und der beiliegenden Zeichnung.

Kurze Beschreibung der Zeichnungen

Figur 1 zeigt eine Anordnung mit einem Generator und einem aktiven Brückengleichrichter in vereinfachter, schematischer Darstellung.

Figur 2 zeigt Signalverläufe zur Erläuterung der Grundlagen eines Verfahrens gemäß einer Ausführungsform der Erfindung.

Figur 3 zeigt Signalverläufe zur Erläuterung eines Verfahrens gemäß einer Ausführungsform der Erfindung.

Figur 4 zeigt Signalverläufe zur Erläuterung eines Verfahrens gemäß einer Ausführungsform der Erfindung.

Figur 5 veranschaulicht das Wirkprinzip eines Verfahrens gemäß einer Ausführungsform der Erfindung in Form eines Diagramms.

Figur 6 veranschaulicht ein Verfahren gemäß einer Ausführungsform der Erfindung in Form eines Diagramms.

Figur 7 zeigt einen Signalverlauf zur Erläuterung eines Verfahrens gemäß einer Ausführungsform der Erfindung in schematischer Darstellung.

Ausführungsformen der Erfindung

In den Figuren sind einander entsprechende Elemente mit identischen Bezugszeichen angegeben und werden nicht wiederholt erläutert.

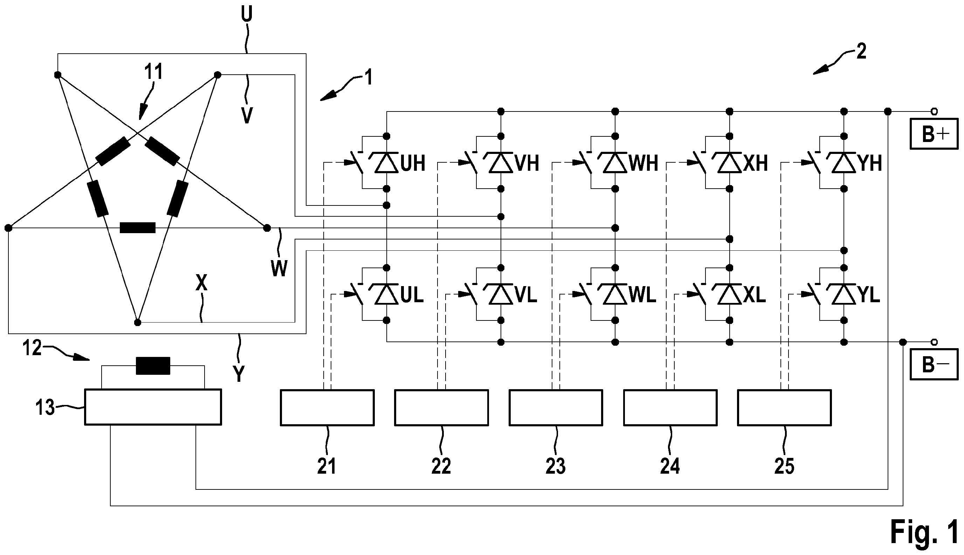

In Figur 1 ist eine Anordnung mit einem Generator 1 und einem aktiven Brückengleichrichter 2, wie sie einer Ausführungsform der vorliegenden Erfindung zu Grunde liegen kann, schematisch veranschaulicht.

Der Generator 1 umfasst einen fünfphasig und in Drudenfußschaltung ausgebildeten Stator 11 und einen Rotor 12. Die einzelnen Statorwicklungen des Stators 11 und die Rotorwicklung des Rotors 12 sind mit üblichen Schaltsymbolen dargestellt, jedoch nicht gesondert bezeichnet.

Der Generator 1 ist mit fünf Phasenanschlüssen U bis Y jeweils über ein- und ausschaltbare, steuerbare Stromventile, hier mit UL bis YL und UH bis YH bezeichnet, an einen ersten Gleichspannungsanschluss B- bzw. einen zweiten Gleichspannungsanschluss B+ angebunden. Der Gleichspannungsanschluss B-kann typischerweise auf Masse liegen).

Das erfindungsgemäße Verfahren wird nachfolgend anhand einer Einleitung eines Phasenkurzschlusses in den Stromventilen UL bis YL eines unteren Gleichrichterzweigs ("Lowside") beschrieben, kann jedoch auch mit den Stromventilen UH bis YH im oberen Gleichrichterzweig ("Highside") durchgeführt werden. Die jeweils beteiligten Stromventile werden im Rahmen dieser Anmeldung als "erste" Stromventile bezeichnet; zumindest diese sind ein- und ausschaltbar sowie steuerbar und beispielsweise als MOSFET ausgebildet. Die ein- und ausschaltbaren, steuerbaren Stromventile UL bis YL und UH bis YH sind in der Figur vereinfacht als Schalter mit parallel geschalteten Zenerdioden veranschaulicht. Die Zenerdioden symbolisieren dabei sowohl die typische Durchbruchseigenschaft eines MOSFET ab einer bestimmten Drain-Source-Spannung, als auch die in MOSFET vorhandene Inversdiode. Die Stromventile UL bis YL und UH bis YH sind, wie allgemein üblich, in einer der Anzahl der Phasenanschlüsse entsprechenden Anzahl von Halbbrücken angeordnet. Die Stromventile UL bis YL und UH bis YH sind jeweils durch dezentrale Steuereinrichtungen 21 bis 25, wie hier mit gestrichelten Ansteuerpfeilen veranschaulicht, steuerbar.

Desweiteren beinhalten die Stromventile UH bis YH und/oder die Stromventile UL bis YL typischerweise eine geeignete Zusatzbeschaltung, um beispielsweise eine Spannungsklammerung auf z.B. 30 V zu ermöglichen.

Ein Generatorregler 13 wertet eine zwischen den Gleichspannungsanschlüssen B+ und B- anliegende Spannung aus und regelt, beispielsweise über eine pulsweitenmodulierte Bestromung der Erregerwicklung des Rotors 12, die Ausgangsleistung des Generators 1.

In Figur 2 sind Strom- und Spannungsverläufe in A bzw. V auf den jeweiligen Ordinaten gegenüber einer Zeit in ms auf einer gemeinsamen Abszisse aufgetragen. Die in Figur 2 dargestellten Strom- und Spannungsverläufe treten in einer nicht erfindungsgemäß betriebenen Anordnung bei einem fünfphasigen Generator mit einem diesem zugeordneten aktiven Brückengleichrichter auf, die im Übrigen der in der Figur 1 gezeigten Anordnung entsprechen kann. Die Strom- und Spannungsverläufe sind in Form der Diagramme 210, 220, 230, 240, 250 und 260 veranschaulicht.

In dem Diagramm 210 ist eine zwischen den Gleichspannungsanschlüssen des Brückengleichrichters anliegende Spannung mit 201 bezeichnet. In dem Diagramm 210 ist ferner ein in das an den aktiven Brückengleichrichter angeschlossene Netz eingespeister Strom in Form des Verlaufs 202 veranschaulicht.

In einem Zeitraum vom ca. 73,4 bis 73,8 ms befindet sich der aktive Brückengleichrichter im regulären Gleichrichterbetrieb. Zu einem Zeitpunkt von 73,8 ms tritt im dargestellten Beispiel ein Lastabwurf, beispielsweise durch Abschaltung eines Verbrauchers, auf. Die zwischen den Gleichspannungsanschlüssen des aktiven Brückengleichrichters anliegende Spannung 201 steigt hierdurch rapide an. Überschreitet die zwischen den Gleichspannungsanschlüssen des aktiven Brückengleichrichters anliegende Spannung 201 einen (nicht dargestellten) oberen Schwellwert, werden die mehrfach erläuterten Maßnahmen eingeleitet, beispielsweise die Stromventile des unteren Gleichrichterzweigs angeschaltet.

Die entsprechenden Phasen des Generators werden hierdurch kurzgeschlossen, sodass die zwischen den Gleichspannungsanschlüssen des aktiven Brückengleichrichters anliegende Spannung 201 nicht weiter ansteigt. Wie ersichtlich, sinkt die zwischen den Gleichspannungsanschlüssen des aktiven Brückengleichrichters anliegende Spannung 201 nach kurzem Verharren auf einem Plateau wieder ab und erreicht zu einem Zeitpunkt von ca. 74,4 ms ein Minimum. Wird durch die zwischen den Gleichspannungsanschlüssen des aktiven Brückengleichrichters anliegende Spannung 201 ein (ebenfalls nicht dargestellter) unterer Schwellwert unterschritten, geht der Gleichrichter wieder in den regulären Gleichrichterbetrieb über.

Ist der Generator noch nicht ausreichend entregt, steigt die zwischen den Gleichspannungsanschlüssen des aktiven Brückengleichrichters anliegende Spannung 201 erneut an, überschreitet den oberen Schwellwert und es kommt erneut zu einem Phasenkurzschluss, im dargestellten Beispiel bei ca. 74,6 ms. Die wiederholte Einleitung und Aufhebung des Phasenkurzschlusses setzt sich so lange fort, bis der Strom ausreichend abgeklungen ist.

In dem Diagramm 220 der Figur 2 ist der Verlauf einer der Phasenspannungen einer entsprechenden Anordnung aus einem Generator und einem aktiven Brückengleichrichter veranschaulicht und mit 203 bezeichnet. Der Generator ist im dargestellten Beispiel, wie erwähnt, als fünfphasiger Generator ausgebildet, so dass sich bei Überlagerung der einzelnen Phasenspannungen ein in Diagramm 230 gezeigter Gesamtverlauf 204 ergibt. Wie ersichtlich, beträgt das Maximum der Phasenspannungen 204 vor dem Lastabwurfsereignis bei ca. 73,8 ms aufgrund einer Regelung des Erregerstroms ca. 15 V. Nach dem Lastabwurfsereignis bei ca. 73,8 ms kommt es zu einem entsprechenden Anstieg dieser Phasenspannungen 204 auf knapp 30 V, aufgrund der zu Figur 1 beschriebenen Spannungsklammerung. In den Zeiträumen, in denen die Generatorphasen kurzgeschlossen sind, fallen sämtliche Phasenspannungen auf 0 V ab.

In dem Diagramm 240 sind die Phasenströme in einer entsprechenden elektrischen Maschine bzw. einem aktiven Brückengleichrichter in Form der Verläufe 205 veranschaulicht. Man erkennt, dass insbesondere in den Phasen aktiver Gleichrichtung (ersichtlich aus den in dem Diagramm 230 veranschaulichten Phasenspannungen 204) die Einhüllende der Phasenströme 205 und damit auch der theoretische Abgabestrom des Generators reduziert ist und während der Kurzschlussphasen ein Aufschwingen der Phasenströme erfolgt.

In dem Diagramm 250 ist ein durch eine elektrische Maschine bzw. eine Anordnung aus einer entsprechenden elektrischen Maschine und einem aktiven Brückengleichrichter theoretisch abgegebener Strom veranschaulicht, der sich einstellen würde, wenn der aktive Brückengleichrichter kontinuierlich im regulären Gleichrichterbetrieb betrieben würde. Das Diagramm 260 veranschaulicht in Form des Verlaufs 207 den Erregerstrom, also einen durch einen Rotor einer elektrischen Maschine fließenden Strom.

In Figur 3 sind Strom- und Spannungsverläufe, welche sich aus einer Ansteuerung einer entsprechenden Anordnung aus einem Generator und einem aktiven Brückengleichrichter gemäß einer besonders bevorzugten Ausführungsform der Erfindung ergeben, veranschaulicht. Diagramme, Verläufe usw., die jenen in der zuvor dargestellten Figur 2 entsprechen, sind mit um 100 inkrementierten Bezugszeichen veranschaulicht. Auf eine Darstellung einer einzelnen Phasenspannung 203 wie in dem Diagramm 220 der Figur 2 und des Erregerstromverlaufs 207 wie in dem Diagramm 260 der Figur 2 wurde verzichtet, die Anordnung der übrigen Diagramme 310, 330, 340 und 350 und die in diesen gezeigten Strom- und Spannungsverläufe 301, 302, 304, 305 und 306 entsprechen jenen der Figur 2. Die Zeitskala in Figur 3 weicht von jener der Figur 2 ab.

Wird, wie gemäß Figur 3 ab ca. 6,0 ms der Fall, eine Einleitung und Aufhebung der Phasenkurzschlüsse synchron zum theoretischen Abgabestrom des Generators, der in Diagramm 350 in Form des Verlaufs 306 veranschaulicht ist, vorgenommen, und damit abgestimmt mit der Eigenfrequenz der elektrischen Maschine, kommt es im dargestellten Beispiel bereits zum Zeitpunkt ca. 9 ms dazu, dass sich die Phasenströme, wie in Form der Verläufe 305 in dem Diagramm 340 veranschaulicht, zu einem Wert 0 A aufaddieren. Durch eine phasensynchrone Einleitung und Aufhebung der Phasenkurzschlüsse (siehe insbesondere die Diagramme 330 und 350 in der Zusammenschau) wird eine vorhandene Eigenschwingung stärker angeregt und damit ein Nullpunkt in den summierten Phasenströmen in dem Erregerstrom erreicht.

Wie bereits erläutert, versteht sich, dass nicht notwendigerweise eine phasensynchrone Einleitung und Aufhebung der Phasenkurzschlüsse erfolgen muss. Es kann auch vorgesehen sein, dass die Frequenz der Einleitung und Aufhebung der Phasenkurzschlüsse einem Vielfachen der Frequenz des Erregerstroms entspricht oder eine nur näherungsweise Synchronizität eingestellt wird.

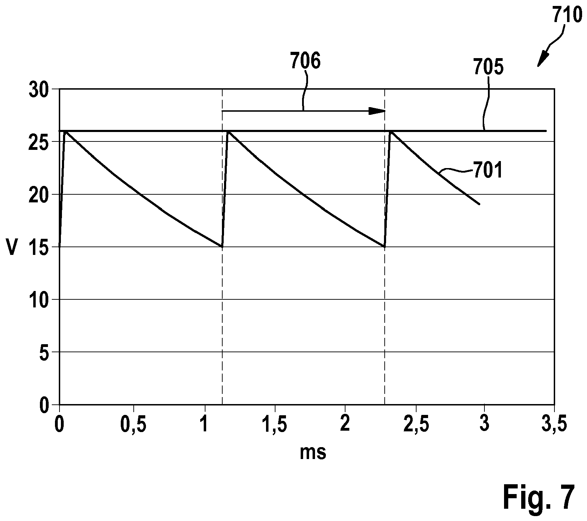

Ein Spannungsverlauf gemäß dem Diagramm 310 der Figur 3 ist in Figur 7 nochmals schematisch veranschaulicht. Auf die Erläuterungen am Ende wird daher bereits an dieser Stelle hingewiesen.

In Figur 4 sind Signalverläufe zur Erläuterung eines Verfahrens gemäß einer Ausführungsform der Erfindung schematisch veranschaulicht. Hierbei sind ein Erregerstrom 401 ohne aufgeprägte Schwingung und ein Erregerstrom 402 mit entsprechend erhöhter Schwingung in A auf der Ordinate gegenüber einer Zeit in s auf der Abszisse aufgetragen. Mit 403 ist der Zeitpunkt bezeichnet, zu dem der Verlauf 402 erstmals den Wert 0 A erreicht. Dieser liegt deutlich vor dem (nicht gesondert bezeichneten) Zeitpunkt, zu dem der Erregerstrom 401 den Nullwert erreicht. Weitere Details wurden bereits zuvor erläutert.

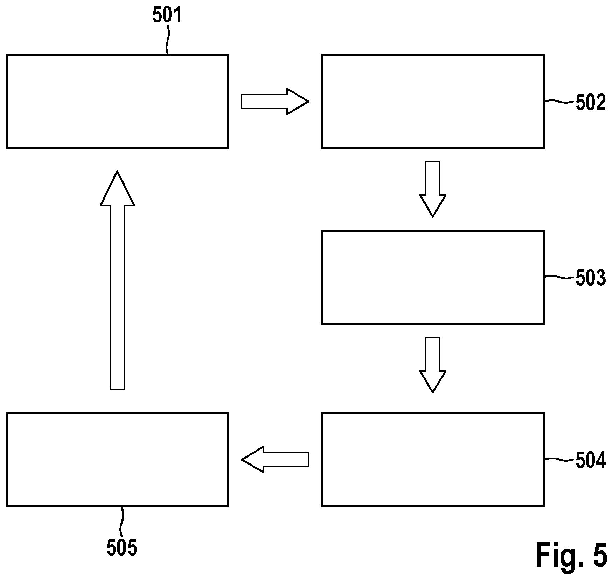

In Figur 5 ist das Wirkprinzip eines Verfahrens gemäß einer Ausführungsform der Erfindung in Form eines schematischen Diagramms veranschaulicht.

Wie erläutert führt die Aktivierung eines Phasenkurzschlusses (Block 501) zu einem Gleichanteil in den Phasen, der (Block 502) transformatorisch auf den Rotor der elektrischen Maschine (vgl. beispielsweise Rotor 12 in Figur 1) übertragen wird. Zu einem Zeitpunkt eines niedrigen Erregerstroms sind auch die Phasenströme sehr niedrig (Block 503), so dass eine Deaktivierung des Phasenkurzschlusses (Block 504) vorzugsweise zu diesem Zeitpunkt erfolgen sollte, um die Verlustleistungen in den Stromventilen des aktiven Brückengleichrichters (Block 505) zu reduzieren. Ist ein Phasenkurzschluss damit zu einem günstigen Zeitpunkt aufgehoben worden, wird dieser vorzugsweise zumindest teilweise synchronisiert mit einer Eigenschwingung des Erregerstroms bzw. der elektrischen Maschine oder dann, wenn ein vorgegebener Schwellwert durch die Ausgangsspannung des Gleichrichters überschritten ist, wieder eingeleitet (Block 501), so dass der Ausgangspunkt wieder erreicht ist.

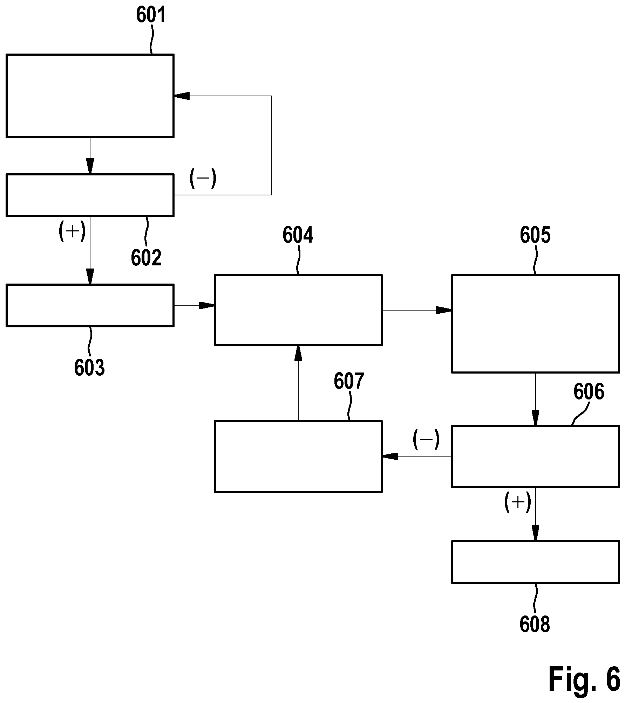

Figur 6 veranschaulicht ein Verfahren gemäß einer Ausführungsform der Erfindung in Form eines Diagramms.

In dem Verfahren erfolgt, wie mit Block 601 veranschaulicht, eine kontinuierliche Berechnung der Eigenfrequenz der elektrischen Maschine bzw. von deren Periodendauer, anhand des Phasenspannungsverlaufs, die mit der Drehzahl korreliert, oder beispielsweise anhand von Drehzahl und Winkellage.

Es wird kontinuierlich oder periodisch überprüft, wie mit Block 602 veranschaulicht, ob eine Ausgangsspannung zwischen den Gleichspannungsanschlüssen des aktiven Brückengleichrichters einen oberen Schwellwert überschreitet. Falls nicht (-) wird das Verfahren zyklisch mit den Schritten, die mit den erläuterten Blöcken 601 und 602 veranschaulicht sind, fortgesetzt. Falls ja (+) wird, wie mit Block 603 veranschaulicht, ein Phasenkurzschluss eingeleitet.

Wie mit Block 604 veranschaulicht, wird ein Zeitmesser gestartet und der Phasenkurzschluss gelöst, nachdem eine Periodendauer, die in dem Schritt gemäß Block 601 bestimmt wurde (oder ein Vielfaches, wie erläutert), verstrichen ist. Dies ist mit Block 605 veranschaulicht. Der Phasenkurzschluss wird auch dann gelöst, wenn die Ausgangsspannung zwischen den Gleichspannungsanschlüssen des aktiven Brückengleichrichters einen vorgegebenen unteren Schwellwert noch nicht unterschritten hat.

Wie mit Block 606 veranschaulicht, wird nun überprüft, ob die Phasenspannung oder der Erregerstrom (also wieder, verallgemeinert gesprochen, ein durch einen Rotor der elektrischen Maschine fließender Strom) einen vorgegebenen Minimalwert unterschritten hat. Falls nein (-) wird weiter mit einem alternierenden Phasenkurzschluss-/Gleichrichterbetrieb fortgefahren, d.h., wie mit Block 607 veranschaulicht, ein Phasenkurzschluss wieder eingeleitet, wenn die Ausgangsspannung zwischen den Gleichspannungsanschlüssen des aktiven Brückengleichrichters den erwähnten oberen Schwellwert überschreitet, die Zeitmessung gemäß Block 604 wieder gestartet und das Verfahren wie erläutert bis zu dem mit Block 606 veranschaulichten Überprüfungsschritt fortgesetzt. Falls ja (+) ist der Erregerstrom bzw. Phasenstrom ausreichend abgeklungen, so dass weiter in der regulären Gleichrichtung, d.h. ohne weitere Phasenkurzschlüsse, verblieben werden kann, wie mit Block 608 veranschaulicht. Das Verfahren kann dann mit dem Block 601 entsprechenden Schritt fortgesetzt werden.

Wie bereits erwähnt, ist ein Spannungsverlauf gemäß dem Diagramm 310 der Figur 3 in Figur 7 nochmals schematisch veranschaulicht. Der in Figur 3 mit 301 bezeichnete Spannungsverlauf ist in der Figur 7 mit 701 bezeichnet, wobei auch hier in einem Diagramm 710 eine Zeit in ms auf der Abszisse gegen eine Spannung in V auf der Ordinate aufgetragen ist. Zusätzlich ist hier der obere Schwellwert der Ausgangsspannung des Brückengleichrichters mit 705 bezeichnet.

Erreicht die Ausgangsspannung des Brückengleichrichters, nämlich der Spannungsverlauf 701, den oberen Schwellwert 705, wird, wie mehrfach erläutert, ein Phasenkurzschluss eingeleitet. Im dargestellten Beispiel wird der Phasenkurzschluss nach Verstreichen eines vorgegebenen Zeitraums wieder aufgehoben. Das erfindungsgemäße Verfahren sieht vor, diese Zeit zumindest teilweise mit der Eigenfrequenz der elektrischen Maschine bzw. einem entsprechenden Signal, beispielsweise dem Verlauf eines durch einen Rotor der elektrischen Maschine fließenden Stroms zu synchronisieren, so dass ein Zeitraum, der in der Figur 7 mit 706 bezeichnet ist, mit ggf. vorhandenen möglichen Abweichungen einer Periodendauer dieses durch den Rotor der elektrischen Maschine fließenden Stroms (oder einem Vielfachen hiervon) entspricht. Auf diese Weise wird die Eigenschwingung angeregt.

**Patentansprüche**

1. Verfahren (100) zum Ansteuern einer zumindest generatorisch betreibbaren, mehrphasigen elektrischen Maschine (1), deren Phasenanschlüsse (U-Y) in einem aktiven Brückengleichrichter (2) jeweils über ein- und ausschaltbare, ansteuerbare erste Stromventile (UL-YL) an einen ersten Gleichspannungsanschluss (B-) und über zweite Stromventile (UH-YH) an einen zweiten Gleichspannungsanschluss (B+) angebunden sind, wobei das Verfahren umfasst, in einem generatorischen Betrieb der elektrischen Maschine (1) nach Auftreten eines Lastabwurfs mehrfach Phasenkurzschlüsse der Phasenanschlüsse (U-Y) über die ersten Stromventile (UL-YL) einzuleiten und aufzuheben, **dadurch gekennzeichnet, dass** eine eine Eigenfrequenz der elektrischen Maschine (1) kennzeichnende Größe ermittelt und die ersten Stromventile (UL-YL) zum Einleiten und Aufheben der Phasenkurzschlüsse auf Grundlage der die Eigenfrequenz der elektrischen Maschine (1) kennzeichnenden Größe mit einer Schaltfrequenz angesteuert werden.

2. Verfahren (100) nach Anspruch 1, bei dem die Schaltfrequenz in einem Frequenzbereich liegt, dessen Untergrenze ein ganzzahliges Vielfaches der Eigenfrequenz abzüglich eines vorgegebenen Toleranzwerts und dessen Obergrenze das ganzzahlige Vielfache der Eigenfrequenz zuzüglich des vorgegebenen Toleranzwerts beträgt.

3. Verfahren nach Anspruch 2, bei dem, wenn die Eigenfrequenz der elektrischen Maschine (1) $f_E$ beträgt, die Schaltfrequenz $(f_E \times m) \pm (k \times f_E)$ beträgt, wobei m das ganzzahlige Vielfache mit einem Wert von 1 bis 5 und k ein den vorgegebenen Toleranzwert definierender Wert von 0 bis 0,4 ist.

4. Verfahren (100) nach Anspruch 1, bei dem eine Periodendauer der Schaltfrequenz in einem Zeitbereich liegt, dessen Untergrenze ein ganzzahliges Vielfaches einer Periodendauer der Eigenfrequenz abzüglich eines Toleranzwerts und dessen Obergrenze das ganzzahlige Vielfache der Periodendauer der Eigenfrequenz zuzüglich des Toleranzwerts beträgt.

5. Verfahren nach einem der vorstehenden Ansprüche, bei als die die Eigenfrequenz der elektrischen Maschine (1) kennzeichnende Größe eine ermittelte Drehzahl der elektrischen Maschine (1) zum Zeitpunkt der Durchführung des Verfahrens oder ein hiervon abgeleiteter Wert verwendet wird.

6. Verfahren nach Anspruch 5, bei dem unter Verwendung der Drehzahl der elektrischen Maschine (1) zum Zeitpunkt der Durchführung des Verfahrens und unter Verwendung einer Polpaarzahl der elektrischen Maschine (1) die Eigenfrequenz und/oder deren Periodendauer bestimmt wird.

7. Verfahren nach einem der vorstehenden Ansprüche, bei dem das mehrfache Einleiten der Phasenkurzschlüsse beendet wird, wenn der durch den Rotor (12) der elektrischen Maschine (1) fließende Strom oder zumindest ein weiteres Stromsignal der elektrischen Maschine erstmalig unterhalb eines Schwellwerts liegt.

8. Verfahren nach einem der vorstehenden Ansprüche, bei dem die ersten Stromventile (UL-YL) zum Einleiten der Phasenkurzschlüsse auf Grundlage von Einschaltbedingungen eingeschaltet und zum Aufheben der Phasenkurzschlüsse auf Grundlage von Ausschaltbedingungen ausgeschaltet werden, wobei die Ein- und/oder die Ausschaltbedingungen auf Grundlage der die Eigenfrequenz der elektrischen Maschine (1) kennzeichnenden Größe vorgegeben werden.

9. Verfahren nach Anspruch 8, bei dem die Einschaltbedingungen zumindest umfassen, dass eine Ausgangsspannung zwischen dem ersten Gleichspannungsanschluss (B-) und dem zweiten Gleichspannungsanschluss (B+) einen oberen Schwellwert überschritten hat, wobei eine Schwellwerteinstellung des oberen Schwellwerts in Abhängigkeit von der die Eigenfrequenz der elektrischen Maschine (1) kennzeichnenden Größe vorgenommen wird.

10. Verfahren nach Anspruch 8 oder 9, bei dem die Ausschaltbedingungen zumindest umfassen, dass eine Ausgangsspannung zwischen dem ersten Gleichspannungsanschluss (B-) und dem zweiten Gleichspannungsanschluss (B+) einen unteren Schwellwert unterschritten hat, wobei eine Schwellwerteinstellung des unteren Schwellwerts in Abhängigkeit von der die Eigenfrequenz der elektrischen Maschine (1) kennzeichnenden Größe vorgenommen wird.

11. Verfahren nach Anspruch 9 oder 10, bei dem die Schwellwerteinstellung ferner in Abhängigkeit von einem Entladestrom eines mit dem ersten und/oder zweiten Gleichspannungsanschluss (B+, B-) verbundenen kapazitiven Elements und dessen Kapazität vorgenommen wird.

**12.** Verfahren nach einem der Ansprüche 8 bis 11, bei dem die Einschaltbedingungen zumindest umfassen, dass ein vorgegebener Einschaltzeitpunkt erreicht ist und/oder bei dem die Ausschaltbedingungen zumindest umfassen, dass ein vorgegebener Ausschaltzeitpunkt erreicht ist.

**13.** Verfahren nach einem der vorstehenden Ansprüche, bei dem das Einleiten und Aufheben der Phasenkurzschlüsse unterbunden wird, wenn in den Phasenanschlüssen (U-Y) fließende Ströme in Summe 0 A ergeben oder unterhalb eines vorgegebenen Schwellwerts liegen.

**14.** Steuereinrichtung, die programmtechnisch dazu eingerichtet ist, ein Verfahren nach einem der vorstehenden Ansprüche durchzuführen.

**15.** Computerprogramm, das eine Steuereinrichtung nach Anspruch 14 dazu veranlasst, ein Verfahren nach einem der Ansprüche 1 bis 13 durchzuführen, wenn es auf der Steuereinrichtung ausgeführt wird.

**16.** Maschinenlesbares Speichermedium mit einem darauf gespeicherten Computerprogramm nach Anspruch 15.

**Claims**

**1.** Method (100) for driving an at least generator-operable, multi-phase electrical machine (1), the phase connections (U-Y) of which are connected in an active bridge rectifier (2) to a first DC voltage terminal (B-) via first current valves (UL-YL) which can be turned on and off and can be driven, and to a second DC voltage terminal (B+) via second current valves (UH-YH), wherein the method comprises initiating and cancelling multiple phase short circuits of the phase connections (U-Y) via the first current valves (UL-YL) in a generator operation of the electrical machine (1) after a load drop occurs, **characterized in that** a variable characterizing a natural frequency of the electrical machine (1) is determined and the first current valves (UL-YL) for initiating and cancelling the phase short circuits are driven with a switching frequency on the basis of the variable characterizing the natural frequency of the electrical machine (1).

**2.** Method (100) according to claim 1, in which the switching frequency is in a frequency range whose lower limit is an integer multiple of the natural frequency minus a predetermined tolerance value and whose upper limit is an integer multiple of the natural frequency plus the predetermined tolerance value.

**3.** Method according to claim 2, in which, when the natural frequency of the electrical machine (1) is $f_E$, the switching frequency is $(f_E \times m) \pm (k \times f_E)$, where m is an integer multiple with a value of 1 to 5 and k is a value of 0 to 0.4 defining the predetermined tolerance value.

**4.** Method (100) according to claim 1, in which a period duration of the switching frequency is in a time range whose lower limit is an integer multiple of a period duration of the natural frequency minus a tolerance value and whose upper limit is an integer multiple of the period duration of the natural frequency plus the tolerance value.

**5.** Method according to any one of the preceding claims, in which as the variable characterizing the natural frequency of the electrical machine (1) a determined rotational speed of the electrical machine (1) at the time of performing the method or a value derived therefrom is used.

**6.** Method according to claim 5, in which the natural frequency and/or its period duration is determined using the rotational speed of the electrical machine (1) at the time of performing the method, using a number of pole pairs of the electrical machine (1).

**7.** Method according to any one of the preceding claims, in which the multiple initiation of phase short circuits is terminated when the current flowing through the rotor (12) of the electrical machine (1) or at least one further current signal of the electrical machine is below a threshold value for the first time.

**8.** Method according to any one of the preceding claims, in which the first current valves (UL-YL) are turned on for initiating the phase short circuits based on turn-on conditions and are turned off for cancelling the phase short circuits based on turn-off conditions, wherein the turn-on and/or turn-off conditions are predetermined based on the varible characterizing the natural frequency of the electrical machine (1).

9. Method according to claim 8, in which the turn-on conditions at least comprise that an output voltage between the first DC voltage terminal (B-) and the second DC voltage terminal (B+) has exceeded an upper threshold value, wherein a threshold value adjustment of the upper threshold value is performed as a function of the variable characterizing the natural frequency of the electrical machine (1).

10. Method according to claim 8 or 9, in which the turn-off conditions at least comprise that an output voltage between the first DC voltage terminal (B-) and the second DC voltage terminal (B+) has fallen below a lower threshold value, wherein a threshold value adjustment of the lower threshold is performed as a function of the variable characterizing the natural frequency of the electrical machine (1).

11. Method according to claim 9 or 10, in which the threshold value adjustment is further performed in dependence on a discharge current of a capacitive element connected to the first and/or second DC voltage terminal (B+, B-) and its capacitance.

12. Method according to any one of claims 8 to 11, in which the turn-on conditions at least comprise that a predetermined turn-on time is reached and/or in which the turn-off conditions at least comprise that a predetermined turn-off time is reached.

13. Method according to any one of the preceding claims, in which the initiation and cancellation of phase short circuits is inhibited if currents flowing in the phase terminals (U-Y) add up to 0 A or are below a predetermined threshold.

14. A control device programmatically adapted to perform a method according to any one of the preceding claims.

15. A computer program that causes a control device according to claim 14 to perform a method according to any one of claims 1 to 13 when executed on the control device.

16. Machine readable storage medium with a computer program according to claim 15 stored thereon.

**Revendications**

1. Procédé (100) de commande d'une machine électrique polyphasée (1) pouvant fonctionner au moins en mode générateur, dont les bornes de phase (U-Y) dans un redresseur en pont actif (2) sont respectivement reliées à une première borne de tension continue (B-) par l'intermédiaire de premières valves de courant (UL-YL) pouvant être commandées et fermées/ouvertes, et à une seconde borne de tension continue (B+) par l'intermédiaire de secondes valves de courant (UH-YH), dans lequel le procédé comporte, dans un mode générateur de la machine électrique (1), après l'apparition d'une rupture de charge, l'étape consistant à déclencher et interrompre plusieurs fois des courts-circuits de phase des bornes de phase (U-Y) par l'intermédiaire des premières valves de courant (UL-YL), **caractérisé en ce qu'**une grandeur caractérisant une fréquence propre de la machine électrique (1) est déterminée et les premières valves de courant (UL-YL) sont commandées avec une fréquence de commutation pour déclencher et interrompre les courts-circuits de phase sur la base de la grandeur caractérisant la fréquence propre de machine électrique (1).

2. Procédé (100) selon la revendication 1, dans lequel la fréquence de commutation se situe dans une plage de fréquences dont la limite inférieure est un multiple entier de la fréquence propre moins une valeur de tolérance prédéfinie, et dont la limite supérieure est le multiple entier de la fréquence propre plus la valeur de tolérance prédéfinie.

3. Procédé selon la revendication 2, dans lequel, lorsque la fréquence propre de la machine électrique (1) est $f_E$, la fréquence de commutation est égale à $(f_E \times m) \pm (k \times f_E)$, où m représente le multiple entier ayant une valeur comprise entre 1 et 5 et k représente une valeur définissant la valeur de tolérance prédéfinie comprise entre 0 et 0,4.

4. Procédé (100) selon la revendication 1, dans lequel une durée de période de la fréquence de commutation se situe sur un intervalle de temps dont la limite inférieure est un multiple entier d'une durée de période de la fréquence propre plus une valeur de tolérance prédéfinie, et dont la limite supérieure est le multiple entier de la durée de période de la fréquence propre plus la valeur de tolérance prédéfinie.

5. Procédé selon l'une des revendications précédentes, dans lequel une vitesse de rotation de la machine électrique (1) déterminée au moment de la mise en œuvre du procédé, ou une valeur déduite de celle-ci, est utilisée en tant que grandeur caractérisant la fréquence propre de la machine électrique (1).

6. Procédé selon la revendication 5, dans lequel la fréquence propre et/ou sa durée de période est déterminée en utilisant la vitesse de rotation de la machine électrique (1) au moment de la mise en œuvre du procédé et en utilisant un nombre de paires de pôles de la machine électrique (1) .

7. Procédé selon l'une des revendications précédentes, dans lequel les déclenchements répétés des courts-circuits de phase prennent fin lorsque le courant circulant à travers le rotor (12) de la machine électrique (1), ou au moins un signal de courant supplémentaire de la machine électrique, est pour la première fois inférieur à une valeur de seuil.

8. Procédé selon l'une des revendications précédentes, dans lequel les premières valves de courant (UL-YL) sont fermées pour déclencher les courts-circuits de phase sur la base de conditions de fermeture et sont ouvertes pour supprimer les courts-circuits de phase sur la base de conditions d'ouverture, dans lequel les conditions de fermeture et/ou d'ouverture sont prédéfinies sur la base de la grandeur caractérisant la fréquence propre de la machine électrique (1).

9. Procédé selon la revendication 8, dans lequel les conditions de fermeture incluent au moins le fait qu'une tension de sortie entre la première borne de tension continue (B-) et la seconde borne de tension continue (B+) a franchi une valeur de seuil supérieure, dans lequel un réglage de valeur de seuil de la valeur de seuil supérieure est effectué en fonction de la grandeur caractérisant la fréquence propre de la machine électrique (1).

10. Procédé selon la revendication 8 ou 9, dans lequel les conditions d'ouverture incluent au moins le fait qu'une tension de sortie entre la première borne de tension continue (B-) et la seconde borne de tension continue (B+) a franchi une valeur de seuil inférieure, dans lequel un réglage de valeur de seuil de la valeur de seuil inférieure est effectué en fonction de la grandeur caractérisant la fréquence propre de la machine électrique (1).

11. Procédé selon la revendication 9 ou 10, dans lequel le réglage de valeur de seuil est en outre effectué en fonction d'un courant de décharge d'un élément capacitif relié à la première et/ou seconde borne de tension continue (B+, B-) et en fonction de sa capacité.

12. Procédé selon l'une des revendications 8 à 11, dans lequel les conditions de fermeture incluent au moins le fait qu'un instant de fermeture est atteint et/ou dans lequel les conditions d'ouverture incluent au moins le fait qu'un instant d'ouverture prédéfini est atteint.

13. Procédé selon l'une des revendications précédentes, dans lequel le déclenchement et l'interruption des courts-circuits de phase sont arrêtés lorsque des courants circulant dans les bornes de phase (U-Y) donnent 0 A au total ou sont inférieurs à une valeur de seuil prédéfinie.

14. Dispositif de commande qui est techniquement programmé pour mettre en œuvre un procédé selon l'une des revendications précédentes.

15. Programme informatique qui permet à un dispositif de commande selon la revendication 14 de mettre en œuvre un procédé selon l'une des revendications 1 à 13, lorsqu'il est exécuté sur le dispositif de commande.

16. Support de mémoire lisible par machine sur lequel est stocké un programme informatique selon la revendication 15.

Fig. 1

Fig. 2

**Fig. 3**

Fig. 4

501

502

503

504

505

Fig. 5

Fig. 6

Fig. 7

**IN DER BESCHREIBUNG AUFGEFÜHRTE DOKUMENTE**

**In der Beschreibung aufgeführte Patentdokumente**

- EP 2706657 A1